# EUROPEAN PATENT APPLICATION

(11) **EP 3 041 037 A1**
(43) Date of publication of application: **06.07.2016**
(21) Application number: 14897887.7
(22) Date of filing: 15.10.2014
(51) Int. Cl.: H01L 21/56, H01L 23/00

(54) **PLASTIC-MOLDED SEMICONDUCTOR INTEGRATED CIRCUIT PACKAGE UNSEALING METHOD AND UNSEALING DEVICE**

(30) Priority: 22.09.2014 JP 2014192630
(71) Applicant: Nippon Scientific Co., Ltd., Tokyo 175-0081 (JP)
(72) Inventor: SUZUKI Satoshi, Tokyo 175-0081 (JP)
(74) Representative: Greenaway, Martin William
(86) International application number: PCT/JP2014/077420
(87) International publication number: WO 2016/046995

(57) **Abstract**

A plastic mold decapsulation method and decapsulation system is provided for decapsulating a semiconductor device molded by plastic. A plastic mold decapsulation method and decapsulation system for decapsulating a plastic molded semiconductor device includes decapsulating the molded semiconductor device using a solution having dissolved metal in a liquid including acid. In this way, it is possible to prevent damage to the metal used in a package such as a bonding wire by a solution used in decapsulation.

## Description

### TECHNICAL FIELD

The present invention is related to decapsulation method and decapsulation system for plastic molded IC package.

### BACKGROUND

A plastic molded IC package (referred to herein as [semiconductor device]) is often decapsulated removing a plastic mold in order to perform a failure analysis of defective products or confirm the state of the manufacturing process of a good product.

A nitric acid, sulfuric acid or a mixture of these are conventionally used for decapsulation of plastic molded semiconductor IC package , for example, Japanese Laid Open Patent No. H6-21130 discloses a decapsulation method of plastic molded semiconductor IC package using a nitric acid, sulfuric acid or a mixture of these.

In order to perform a failure analysis, only the plastic for the molding needs to be dissolved and damage to the metals used in a package, such as a bonding wire, lead frame or a package substrate needs to be minimized. However, when a package is decapsulated using nitric acid, sulfuric acid or a solution of a mixture of these, there was a problem wherein the nitric acid, sulfuric acid or a solution of a mixture of these dissolved even the metal used for a package such as a bonding wire.
That is, previously, since Au (gold) was often used for a bonding wire and an alloy of Ni (nickel) and Fe (iron) for a lead frame, a bonding wire and a lead frame have sufficient resistance to acid with a strong oxidizing strength, however recently bonding wire made from Cu (copper) and Ag (silver) have been developed from the view of heat dissipation and cost. Since these metals readily dissolve in nitric acid etc, when decapsulating a package using nitric acid, sulfuric acid or a mixture of these, nitric acid, sulfuric acid or a mixture of these dissolve a metal used in a package such as a bonding wire which leads to trouble in failure analysis. In addition, a material that is more difficult to dissolve is being used for a mold plastic which makes it more difficult to decapsulate a semiconductor device.

### PRIOR ART

### PATENT DOCUMENTS

Patent Document 1: Japanese Laid Open Patent No. H6-21130

### SUMMARY

Therefore, the present invention provides a decapsulation method and decapsulation system if a sample which can prevent damaging a metal used in a package substrate such as a bonding wire using a I solution to be used for the decapsulation.

The invention related to claim 1 of the present invention is a plastic mold decapsulation method for decapsulating a plastic molded semiconductor device including decapsulating the molded semiconductor device using a solution having dissolved metal in a liquid including acid.

The invention related to claim 2 of the present invention is the plastic mold decapsulation method, wherein the metal is copper, silver and another metal capable of being dissolved in acid.

The invention related to claim 3 of the present invention is the plastic mold decapsulation method, wherein in the solution, the metal is in a state with a saturation rate of more than 70%.

The invention related to claim 4 of the present invention is the plastic mold decapsulation method, wherein a material of the metal is the same as a material of a bonding wire of the plastic molded semiconductor device.

The invention related to claim 5 of the present invention is the plastic mold decapsulation method, wherein in the liquid including acid is a sulfuric acid solution, nitric acid solution or a mixed solution of sulfuric acid and nitric acid.

The invention related to claim 6 of the present invention is the plastic mold decapsulation method, wherein in the solution is used between 10°C and 250°C.

The invention related to claim 7 of the present invention is a plastic mold decapsulation system for decapsulating a plastic molded semiconductor device including decapsulating the molded semiconductor device using a solution having dissolved metal in a liquid including acid.

The invention related to claim 8 of the present invention is a plastic mold decapsulation system, wherein the metal is copper, silver and another metal capable of being dissolved in acid.

The invention related to claim 9 of the present invention is a plastic mold decapsulation system, wherein in the solution, the metal is in a state with a saturation rate of more than 70%.

The invention related to claim 10 of the present invention is a plastic mold decapsulation system, wherein a material of the metal is the same as a material of a bonding wire of the plastic molded semiconductor device.

The invention related to claim 11 of the present invention is a plastic mold decapsulation system, wherein in the liquid including acid is a sulfuric acid solution, nitric acid solution or a mixed solution of sulfuric acid and nitric acid.

The invention related to claim 12 of the present invention is a plastic mold decapsulation system, wherein in the solution is used between 10°C and 250°C.

### EFFECT OF THE INVENTION

According to the present invention, it is possible to prevent damage to a metal used in a package substrate such as a bonding wire by a solution used for decapsulation

### BRIEF EXPLANATION OF THE DRAWINGS

Fig. 1 shows an overall view of a plastic mold decapsulation system according to one embodiment of the present invention;
Fig. 2 shows a dissolution volume ratio of copper at normal temperature;
Fig. 3 shows a dissolution volume ratio of silver in the case of changing a mixing ratio of concentrated sulfuric acid and fuming nitric acid at room temperature;
Fig. 4 shows a dissolution volume ratio of copper according to a first embodiment;
Fig. 5 shows a dissolution volume ratio of copper according to a second embodiment;
Fig. 6 is a flowchart for explaining an embodiment of a liquid chemical creation in a plastic mold decapsulation method according to the embodiment;
Fig. 7 shows a dissolution volume ratio when copper saturation and copper dissolution is at 120 minutes at room temperature;
Fig. 8 shows one example of a decapsulation method in a plastic mold decapsulation system according to an embodiment of the present invention;
Fig. 9 shows one example of a decapsulation method in a plastic mold decapsulation system according to an embodiment of the present invention;
Fig. 10 shows one example of a decapsulation method in a plastic mold decapsulation system according to an embodiment of the present invention; and
Fig. 11 shows one example of a decapsulation method in a plastic mold decapsulation system according to an embodiment of the present invention.

### DESCRIPTION OF EMBODIMENTS

Embodiments of the present invention are be described in detail below with reference to the accompanying drawings.

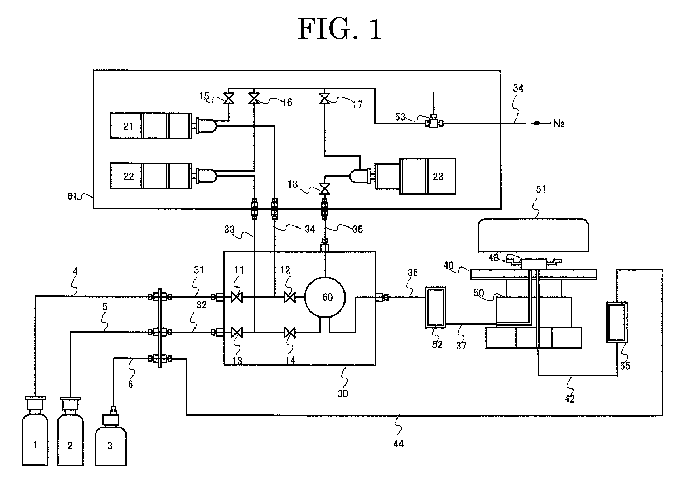

Fig. 1 shows an overall view of a plastic molded decapsulation system according to one embodiment of the present invention

Referring to Fig. 1, the plastic mold system according to an embodiment of the present invention includes a chemical solution container 1, chemical solution container 2, liquid discharge tank 3, pipes 4, 5, 31, 32-35, 37,54, drainage tubes 6, 42, 44, valves 11-18, 36, pumps 21-23, manifold 30, stage 40, sample 43, IC chip 43a, sample stage 50, corrosion resistance block 50a, temperature controlled gold block 50b, rubber seal material 50c, heater 50d, cover 51, gas liquid separator 52, cheese 53, chemical liquid storage unit 60, gas liquid separator 55 and pump chamber 61.

The chemical solution container 1 and chemical solution container 2 are connected with the chemical solution reservoir 60 through pipes 4 and 31 and pipes 5, 32. The pipe 34 connects the pump 21 and the pipe 31. Pipe 33 connects the pump 22 and pipe 32. Pipe 35 connects the pump 23 and the chemical solution reservoir 60. The pipe 35 is arranged with the valve 18. In the pipe 31, the valve 11 is arranged further to the side of the pipe 4 than a confluence point between the pipe 31 and the pump 21. In the pipe 31, the valve 12 is arranged further to the side of the chemical solution reservoir 60 than a confluence point between the pipe 31 and the pump 21. In the pipe 32, the valve 13 is arranged further to the side of the pipe 5 than a confluence point between the pipe 32 and the pump 22. In the 32, the valve 14 is arranged further to the side of the chemical solution reservoir 60 than a confluence point between the pipe 32 and the pump 22.

The chemical solution container 1 and the chemical solution container 2 supply a constant amount of chemical solution to the chemical solution reservoir 60. The amount of chemical solution supplied can be set so as to supply a constant amount in a fixed period of time.

Conventionally, a mixed solution of nitric acid and sulfuric acid was used in the case of protecting a copper bonding wire as the chemical solution and the ratios of nitric acid and sulfuric acid were changed according to the chemical solution temperature. This was because it is difficult to dissolve copper in a mixture solution of sulfuric acid and nitric acid, although copper easily dissolves in nitric acid alone,

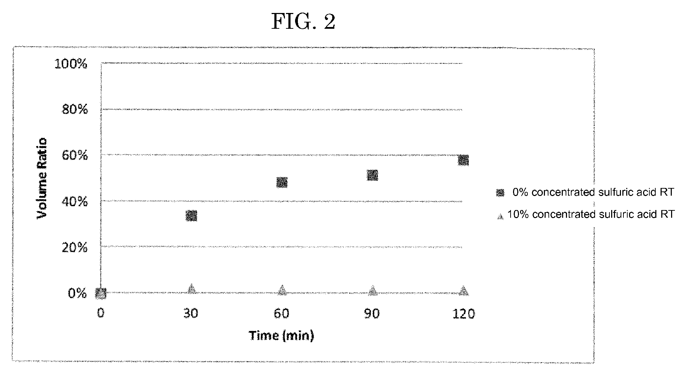

Fig. 2 shows a dissolution volume ratio of copper at normal temperature. Four copper wires with a 0.8mm diameter and 15mum length are put into 20ml of a mixed solution of concentrated sulfuric acid and fuming nitric acid at room temperature and the copper wires are extracted one by one at 30 minutes, 60 minutes, 90 minutes, and at 120 minutes and the result is investigated for the dissolution volume of the copper wire. While 60% of the copper was dissolved in the fuming nitric acid alone at 120 minutes, it is shown that it is possible to suppress the dissolution of a copper wire by adding concentrated sulfuric acid.

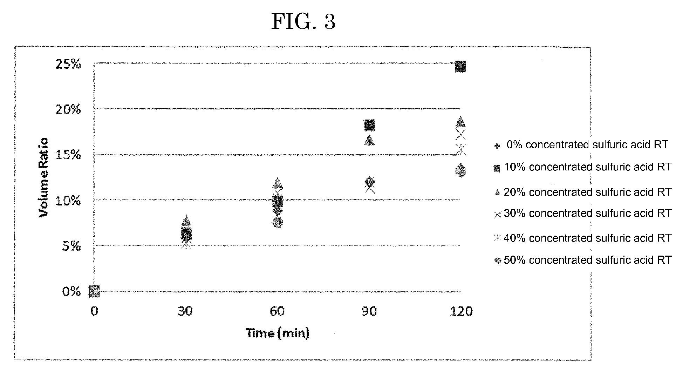

Fig. 3 shows a dissolution volume ratio of silver in the case of changing the mixed ratio of concentrated sulfuric acid and fuming nitric acid at room temperature. 20ml of a dissolved solution in which the mixed ratio of concentrated sulfuric acid and fuming nitric acid at room temperature was changed was created, four silver wires of 0.8mm diameter and 15mm length were placed therein, each were extracted at 30 minutes, 60 minutes, 90 minutes and 120 minutes, and a result of the dissolution volume of silver was investigated. Referring to Fig. 3, in the case of the silver bonding wire, even when the ratio of concentrated sulfuric acid and fuming nitric acid was changed, it can be seen that it is difficult to suppress the dissolution of the silver wire.

In the plastic mold decapsulation method according to an embodiment of the present invention, when performing the removal processing of the plastic for molding, the metal is dissolved in the liquid of nitric acid, sulfuric acid or a mixture of these. In this way, it is possible to suppress the dissolution of the metal used in a package such as a bonding wire.

When a metal of the same type as metal desired to be protected is dissolved in the liquid of nitric acid, sulfuric acid or a mixture of these, the effect of suppressing the dissolution of the metal used in a package such as a bonding wire is increased.

### (First Example)

The solution of 100% of the fuming nitric acid and in which the metal is not dissolved, the solution in which copper is dissolved, and the solution in which silver is dissolved were all used at room temperature.

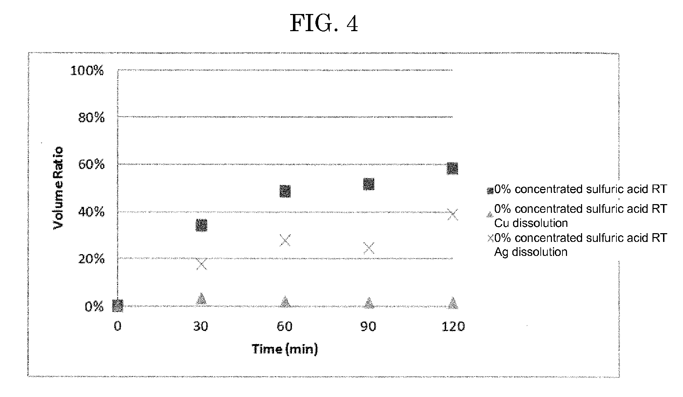

Referring to Fig. 4, compared with the solution in which metal is not dissolved, in the solution in which silver is dissolved, it can be seen that the amount of copper wire dissolution was reduced to 2/3. In addition, in the case of using the solution in which copper is dissolved, it can be seen that only about 3% of the copper wire was dissolved.

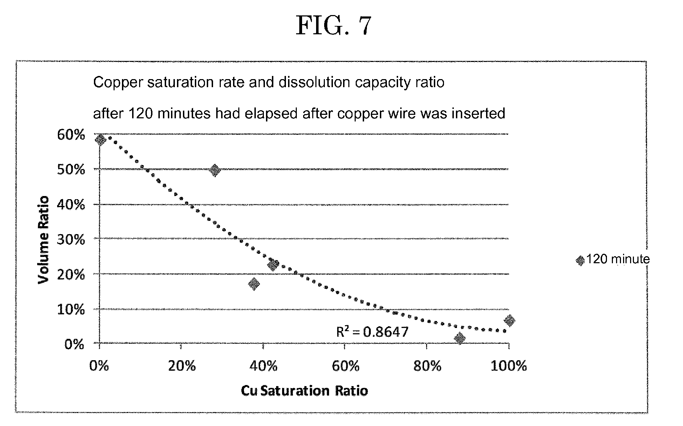

Fig. 7 shows a copper saturation rate when copper was dissolved at room temperature in 20ml of a solution of 100% of the fuming nitric acid, that is, (amount of dissolved copper) / (amount of dissolved copper at saturation), and under these conditions, copper wire with a 0.8mm diameter and 15mm length was inserted and compared with the dissolution capacity ratio after 120 minutes had elapsed. The state when the copper saturation was 0% and the state when copper was not dissolved in the fuming nitric acid, a state when the copper saturation was 100% and a state when copper was saturated are shown in the diagram. Referring to Fig. 7, it can be seen that when the copper saturation rate is 70% or more, the dissolution volume ratio of copper can be reduced to 10% or less, when the copper saturation is 90% or more, the dissolution volume ratio of the copper can be reduced to 5% or less. Therefore, in the solution in the present example, the metal may also be in a state where saturation is 70% or more.

### (Third Example)

A mixed solution of 10% concentrated nitric acid and 90% of the fuming sulfuric acid in which a metal is not dissolved , a solution in which copper is dissolved, and a solution in which silver is dissolved were all used at room temperature.

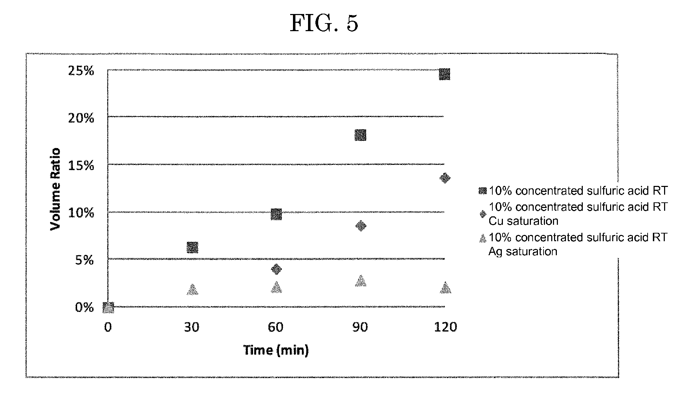

Referring to Fig. 5, compared with the solution in which metal is not dissolved, the solution in which copper is dissolved, it can be seen that the amount of dissolved silver was reduced. In addition, it can be seen that in the case of using a solution dissolved with silver, only about 3% of the silver is dissolved.

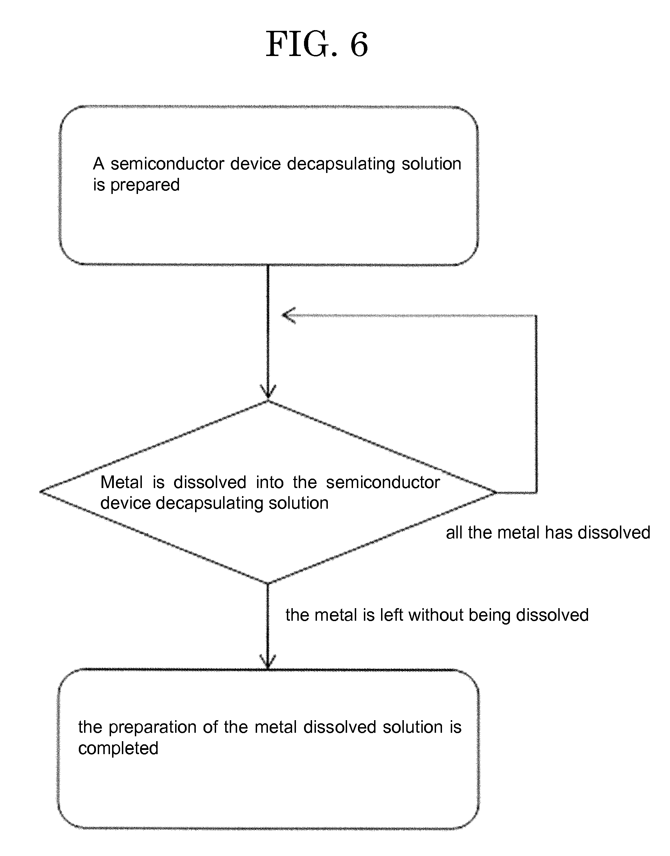

Fig. 6 is a flowchart for explaining one example of making a metal dissolved solution in a saturated state according to the present invention.

First, a semiconductor device decapsulating solution is prepared. The semiconductor device decapsulating solution may be nitric acid, sulfuric acid or a mixture of these.

Next, metal is dissolved into the semiconductor device decapsulating solution. The metal includes copper or silver, and other metals may also be used. After all the metal has dissolved, more metal may be added and dissolved. This is repeated until the solution reaches a saturation point and the metal is left without being dissolved, and the preparation of the metal dissolved solution is completed.

This method is an example and it is also possible to dissolve the same type of metal as the metal to be protected in the solution. In addition, as described above, preparation of the metal dissolved solution may be completed when the metal is in a saturation state of 70% or more.

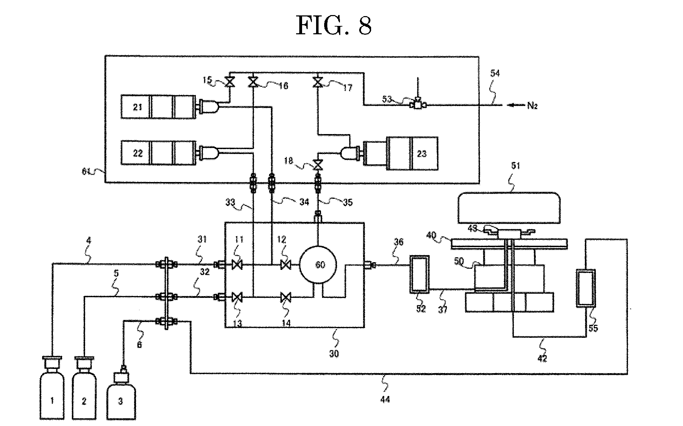

Fig. 8 shows an example of a semiconductor device decapsulation device for use in the method of the present invention.

In the semiconductor device decapsulation system for use in the method of the present invention, first, a semiconductor device decapsulation solution is supplied to a solution reservoir (1). The semiconductor device decapsulation solution may be nitric acid, sulfuric acid or a mixture of these.

Next, a metal is put into the solution reservoir and heated to a dissolution temperature to dissolve the metal (2). Details of the method for dissolving the metal are described later.

The metal may be copper, silver, or copper and silver, and may be the same kind of metal as the metal to be protected.

After the metal is dissolved, the sample is decapsulated (3). Details of the decapsulaation method of the sample are described later.

Lastly, when the decapsulation is completed, the metal dissolved solution is discarded (4).

In the process (2) described above, the metal may be dissolved by repeating the extruding process and the sucking process of the solution using a pump, and in the process (3) described above, the sample may be decapsulated by repeating the extruding process and the sucking process of the metal dissolved solution using a pump.

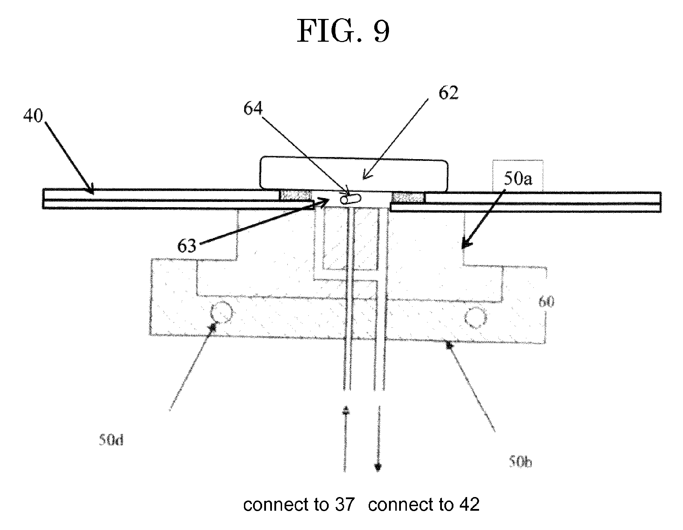

First, referring to Fig. 8 and 9, an upper lid 62 is set on the stage 40, and a metal strip 64 is set in the solution reservoir 63, the amount of the solution in the solution container 1 and the operation time of the system are set by a control panel.

Next, the temperature for heating the solution in a heater 50d is set by the control panel.

After setting, when the solution is put into the solution container 1 and the system is started, the valve 11 is opened, and the pump 21 sucks up a predetermined amount of the solution in the solution container 1 half way up to the pipe 34 through the pipe 4. At this time, valve 12 is closed.

Next valve 11 is closed, and valve 12 is opened, pump 21 pushes the solution sucked up to the middle of the pipe 34 to the solution reservoir 60, and the solution is stored in the solution reservoir 60.

The amount of the solution sucked up by the pump 21 at a time may be one milliliter. Therefore, in the case where the amount of the solution required is 2 milliliters, the sucking up process may be repeated twice. In addition, the amount of the solution to be sucked up at a time may be greater than 1 millimeter.

Next, after valve 18 is opened and valve 12 is closed, the solution stored in the solution reservoir 60 blown from the central hole of the stage 40 by the pump 23 via the gas liquid separator 52 and the piping 37 to hit the metal strip 64 in the solution reservoir 63. The amount of the solution to be sucked up by the pump 23 at one time may be larger than that of the pump 21.

After the solution is blown, the end parts of the solution flow to the gas liquid separator 55 through the pipe 42 from a hole at both ends of the solution reservoir 63.

Next, when the pump 23 is reversed, the solution in the pipe 42 is sucked back, and blown from the hole at both ends of the solution reservoir 63 to the metal strip 64. At this time, an end part of the solution flows from the hole at the center of solution reservoir 63 to the gas liquid separator 52 through pipe 37. That is, in the suck back process, the solution is brought into contact with the metal strip 64 and the dissolution is advanced.

Furthermore, the pump 23 is rotated in the normal direction and the solution is sent to a middle position of the pipe 42 in the same way as described above.

This operation is repeated until a predetermined amount of the metal strip 64 is dissolved. The number of repetitions of this operation may be set by a time calculation according to a condition of the sample, a chemical type, and a temperature of the solution.

In this way, the solution is sucked back as far as the confluence part of the corrosion resistance block 50a by the pump 23. In the same way, the pushing process and suck back process of the solution is repeated predetermined times so as to contact with the metal strip 64 to dissolve the metal strip 64. Therefore, only the solution which comes and goes comes in contact with the metal strip 64 and is dissolved. At this time, the solution is always in a state of hitting the metal strip 64.

The operation is stopped when it reaches the set operating time. At that time, attention should be paid so as not to dispose the solution.

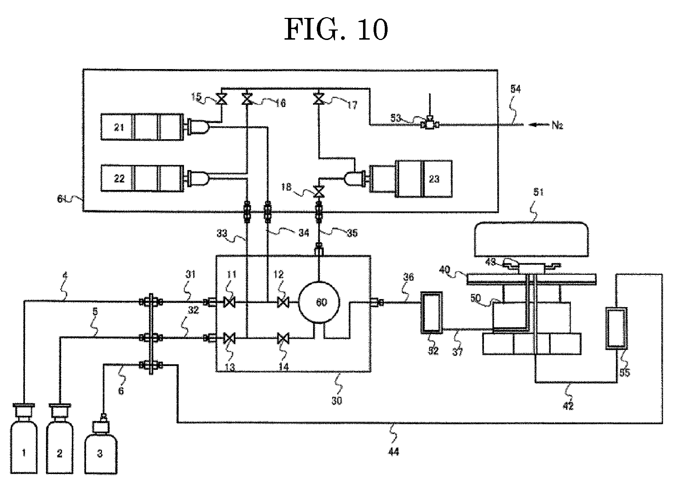

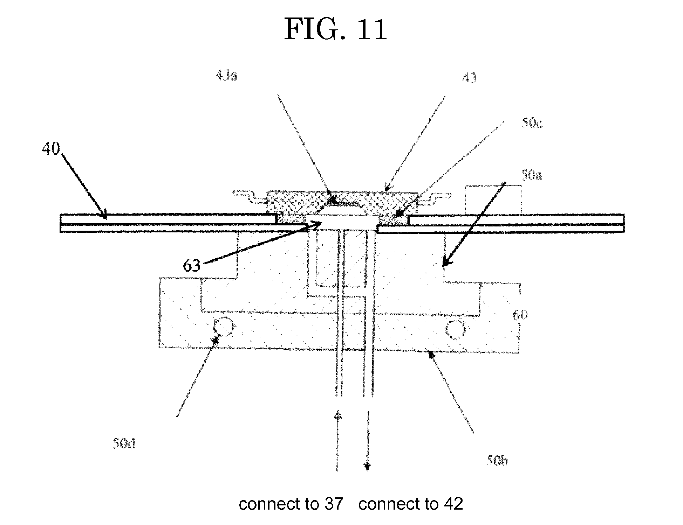

Next, the upper lid 62 is removed and the metal strip 64 is removed from the solution reservoir 63. As is shown in Fig. 10 and 11, the decapsulation surface of a sample 43 is placed face down, set on the stage 40, and the amount of the solution in the solution container 1 and the operating time of the system is set by the control panel.

After setting, the system is started.

The solution is blown to the back side of the sample 43 from the central hole of the stage 40 in which the sample 43 to be decapsulated is placed.

After the solution is blown, the end part of the solution flows as far as the gas-liquid separator 55 through the pipe 42 from the hole at both ends of the tip part of the solution reservoir 63.

Next, when the pump 23 is reversed, the solution in the pipe 42 is sucked back and blown from the hole at both ends of the stage 40 in which the sample 43 to be decapsulated is placed to the back side of the sample 43. At this time, the end part of the solution flows from the hole at the center of the solution reservoir 63 to the gas liquid separator 52 through the pipe 37. That is, in this suck back process, the solution is contacted with the sample 43 and decapsulation is advanced.

Furthermore, the pump 23 is again rotated in the normal direction and the solution is sent in the same way as described above up to the middle position of the pipe 42.

This operation is repeated until an IC package mold compound is removed by a predetermined amount. The number of repetitions of this operation may be set by a time calculation according to a condition of the sample, a chemical type, and a temperature of the solution.

In this way, although an end of the solution once passes the back side of the sample 43, by sucking again using the pump 23, the solution is sucked back as far as the confluence of the corrosion resistance block 50a. In the same way, the pushing process and suck back process are repeated so that the solution contacts the sample 43 predetermined times, and the mold compound of the sample 43 is dissolved. Therefore, only the solution which comes and goes contacts with the sample 43 to dissolve the mold compound of the sample 43. At this time, the solution is always in a state where it hits the sample 43.

When the set operation time is completed, the decapsultion operation of the mold compound of the sample 43 is completed by repeating the pushing process and suck back process of the solution.

In this way, according to this system, by extracting and pushing a solution by a predetermined amount using a pump, it is possible to easily dissolve a metal in the solution. In addition, since it is possible to contact a solution in which a metal is dissolved with a sample and dissolve a mold compound using the same system as the system for performing a process of dissolving the metal in the solution, the treatment process is simple. In this way, according to this device, it is possible to make the decapsulation operation process easier without causing damage to the metal used in a package such as a bonding wire.

## Claims

1. A plastic mold decapsulation method for decapsulating a plastic molded semiconductor device comprising:
decapsulating the molded semiconductor device using a solution having dissolved metal in a liquid including acid.

2. The plastic mold decapsulation method according to claim 1, wherein the metal is copper, silver and another metal capable of being dissolved in acid.

3. The plastic mold decapsulation method according to claim 1, wherein in the solution, the metal is in a state with a saturation rate of more than 70%.

4. The plastic mold decapsulation method according to claim 1, wherein a material of the metal is the same as a material of a bonding wire of the plastic molded semiconductor device.

5. The plastic mold decapsulation method according to claim 1, wherein in the liquid including acid is a sulfuric acid solution, nitric acid solution or a mixed solution of sulfuric acid and nitric acid.

6. The plastic mold decapsulation method according to claim 1, wherein in the solution is used between 10°C and 250°C.

7. A plastic mold decapsulation system for decapsulating a plastic molded semiconductor device comprising:
decapsulating the molded semiconductor device using a solution having dissolved metal in a liquid including acid.

8. The plastic mold decapsulation system according to claim 7, wherein the metal is copper, silver and another metal capable of being dissolved in acid.

9. The plastic mold decapsulation system according to claim 7, wherein in the solution, the metal is in a state with a saturation rate of more than 70%.

10. The plastic mold decapsulation system according to claim 7, wherein a material of the metal is the same as a material of a bonding wire of the plastic molded semiconductor device.

11. The plastic mold decapsulation system according to claim 7, wherein in the liquid including acid is a sulfuric acid solution, nitric acid solution or a mixed solution of sulfuric acid and nitric acid.

12. The plastic mold decapsulation system according to claim 7, wherein in the solution is used between 10°C and 250°C.
